# EUROPEAN PATENT SPECIFICATION

(11) **EP 2 661 598 B1**
(45) Date of publication and mention of the grant of the patent: **01.08.2018**
(21) Application number: 12706025.9
(22) Date of filing: 21.02.2012
(51) Int. Cl.: F28D 15/00, F28D 15/02, F28F 1/24, H01L 23/427, H01L 23/473

(54) **COOLING SYSTEM AND METHOD FOR COOLING A HEAT GENERATING UNIT**
KÜHLSYSTEM UND VERFAHREN ZUM KÜHLEN EINER WÄRMEQUELLE
SYSTÈME DE REFROIDISSEMENT ET PROCÉDÉ POUR REFROIDIR UN ÉLÉMENT GÉNÉRATEUR DE CHALEUR

(43) Date of publication of application: 13.11.2013
(73) Proprietor: Huawei Technologies Co., Ltd., Longgang District Shenzhen, Guangdong 518129 (CN)
(72) Inventor: SHI, Jian, S-16440 Kista (SE); LI, Lei, S-16440 Kista (SE)
(74) Representative: Körber, Martin Hans
(86) International application number: PCT/EP2012/052893
(87) International publication number: WO 2013/123970

(56) References cited:
- WO-A1-2010/087825
- US-A- 5 428 504
- US-A1- 2007 091 578
- US-A1- 2009 038 780
- US-A1- 2011 304 039
- US-B2- 6 937 474
- US-B2- 7 113 404

## Description

### Technical Field

The present invention relates to a cooling system for cooling a heat generating unit. The invention also relates to a method for cooling a heat generating unit.

### Background of the Invention

Cooling systems are used for cooling purposes in different applications, such as e.g. for cooling components such as PCB:s (Printed Circuit Boards) or chips or memory units or radio transceiver units or power amplifiers in telecom equipment etc.

A component to be cooled such as a PCB or a power amplifier may be cooled using a heat sink by placing the component to be cooled against the heat sink base in order to be able to transfer heat from the component to the heat sink. The heat sink may be arranged with cooling fins in order to improve the cooling.

If more cooling power is needed, it is possible to arrange forced cooling of the heat sink, i.e. to arrange a fan that forces a flow of air across the surfaces of the heat sink cooling fins thereby replacing the air around the cooling fins which air has been heated by the heat from the cooling fins with cooler ambient air from the outside of the heat sink.

Normally, radio units, e.g. radio transceivers, are installed on top of a tower or at a similar high mounting position. As the efficiency of e.g. power amplifiers in radio units is not 100%, they emit heat, i.e. the radio unit comprises heat generating components whereby the radio unit needs to be cooled. As mentioned above, one possibility is to cool the radio unit by arranging air cooled heat sinks with or without fans for forced cooling in the radio units.

As the load in telecom systems is increasing, radio units need to be replaced with radio unit that can handle more load.

Due to the often limited base area of a heat generating component in a radio unit and the desire to place more and more functionality on a defined base area of a component, more powerful components are developed. This increase in component capacity may e.g. be accomplished by building higher integration components. This increase in component capacity leads to that more power may be fed to components per component base area than before which in turn results in that the components emit more heat per base area than before when in maximum use e.g. during peak load in telecom systems, i.e. the maximum heat load of components is increasing as they may be fed with more power per square centimetre (W/cm²) base area. This is also the case for components for radio units.

Thus, when replacing radio units with new radio units, the new radio unit usually has a larger heat load. If a radio unit is replaced by a radio unit having more heat load, the heat sink arranged in the new radio unit has to have more cooling power which may be achieved using a heat sink with more cooling fin area, e.g. longer cooling fins, or by arranging a liquid cooling of the radio unit.

US 2006/0023423 A1 shows an expandable heat sink. US 2011/304039 A1 and WO 2010/087825 A1 both disclose a cooling system and a cooling method according to the preambles of the independent claims. US 2007/091578 A1 discloses a further related cooling system and cooling method in which fins for dissipating heat are arranged on a heat dissipater. US 6/937/474 B2 discloses a chipset cooling device of VGA card, whereby in some embodiments the heat pipe is formed in a loop. US 7/113/404 B2 shows a cooling system comprising a heat sink with a closed loop. US 2009/038780 A1 discloses a pumpless cooling system comprising a heat absorbing portion and a heat dissipating portion which are of unitary construction as a sealed container, and at least one driving device.

### Summary of the Invention

The object of the present invention is to provide an improved cooling system for cooling a heat generating unit and an improved method for cooling a heat generating unit.

The object is achieved by arranging a cooling system for cooling a heat generating unit according to claim 1.

The object is further achieved by a method for cooling a heat generating unit according to claim 24. By arranging a cooling system comprising a heat dissipation structure and a heat output connector arranged in the heat generating unit, where the heat dissipation structure is arranged to dissipate heat from at least one heat generating component in the heat generating unit to the heat output connector, where further the exchangeable heat sink unit comprises a heat sink and a heat sink heat dissipation structure and a heat input connector, where the heat input connector is arranged to connect to said heat output connector to dissipate heat from said heat output connector via the heat sink heat dissipation structure to the heat sink, the cooling system may be updated by replacing the exchangeable heat sink with a heat sink having more cooling power without replacing the radio unit. This is advantageous when using radio units which comprise components that may be updated to handle more load by updating the software only, i.e. without replacing the hardware, where by updating the software the heat load of the radio unit is increased which increase in heat load may be taken care of by replacing the heat sink unit with a more powerful heat sink unit, where such a replacement may be done simply and quickly on site, e.g. in a tower where the radio unit is arranged.

According to one embodiment of the invention, the heat generating unit is a radio unit.

According to one embodiment of the invention, the at least one heat generating component is a Printed Circuit Board (PCB), a component on a PCB or a Power Amplifier arranged in the heat generating radio unit.

According to one embodiment of the invention, the heat dissipation structure is a heat pipe arranged to transfer heat from the at least one heat generating component to the heat output connector.

According to one embodiment of the invention, the heat dissipation structure is made of a material with high heat conductivity arranged to transfer heat from the at least one heat generating component to the heat output connector.

According to one embodiment of the invention, the heat output connector and the heat input connector are arranged to be connected against each other in an assembled state of the cooling system thereby allowing for heat transfer by conduction from the heat output connector to the heat input connector.

According to one embodiment of the invention, the heat sink heat dissipation structure is a heat pipe arranged to transfer heat from the heat input connector to the heat sink.

According to one embodiment of the invention, the heat sink heat dissipation structure is made of a material with high heat conductivity arranged to transfer heat from the heat input connector to the heat sink.

According to one embodiment of the invention, the heat output connector and the heat input connector are arranged to be connected against each other in an assembled state of the cooling system thereby allowing for heat transfer between the heat generating unit and the heat sink unit by mass transfer of coolant between the heat generating unit and the heat sink unit.

According to one embodiment of the invention, the coolant output connector and the coolant input connector are arranged to be connected against each other in an assembled state of the cooling system thereby allowing for mass transfer of coolant between the heat sink unit and the heat generating unit from the coolant output connector to the coolant input connector.

Further advantages of the invention will be apparent from the following detailed description.

### Brief Description of the Drawings

The appended drawings are intended to clarify and explain different embodiments of the present invention in which:
- Fig. 1 shows a schematic view of a cooling system according to a first embodiment of the invention for cooling a heat generating unit in a disassembled state,
- Fig. 2 shows another schematic view of a cooling system according to the first embodiment of the invention for cooling a heat generating unit in a disassembled state without heat sink.
- Fig. 3 shows a schematic view of a cooling system according to a second embodiment of the invention for cooling a heat generating unit in a disassembled state, and
- Fig. 4 shows another schematic view of a cooling system according to the second embodiment of the invention for cooling a heat generating unit in a disassembled state without heat sink.

### Detailed Description of the Invention

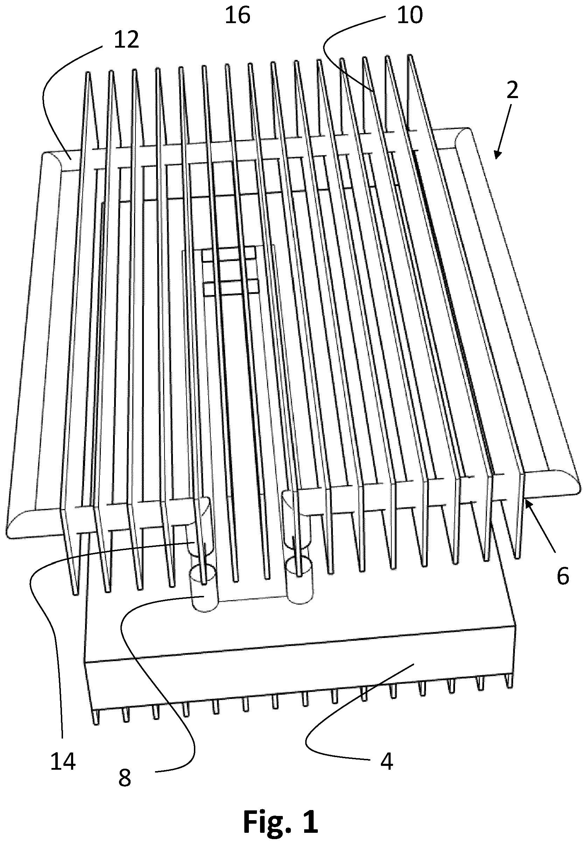

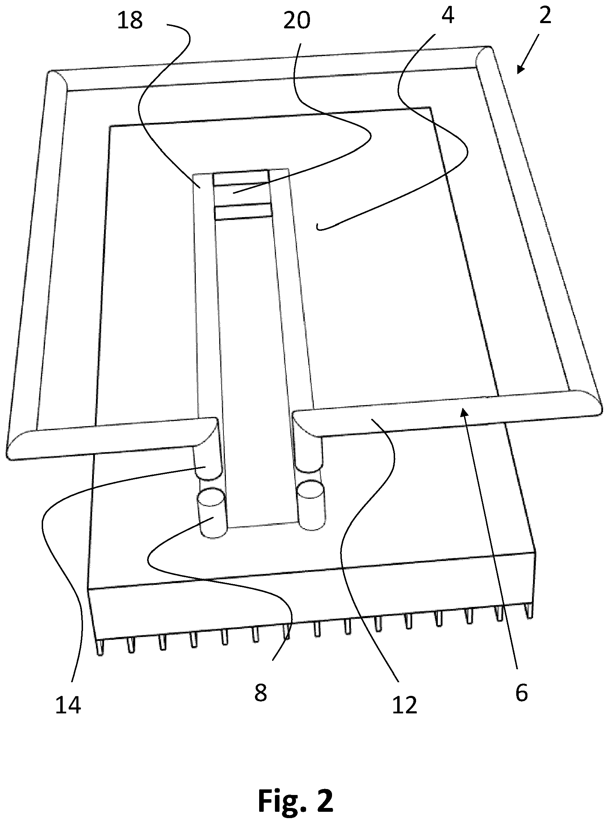

Fig. 1 shows a schematic view of a cooling system 2 according to a first embodiment of the invention for cooling a heat generating unit 4, where the cooling system 2 is shown in a disassembled state for clarity of description, the cooling system 2 comprising an exchangeable heat sink unit 6 being in an assembled state of the cooling system 2 arranged removably connected to the heat generating unit 4 in an assembled state of the cooling system 2, where the cooling system 2 further comprises a heat dissipation structure (not shown in the figure, see instead figure 2) and a heat output connector 8 arranged in the heat generating unit 4, where the heat dissipation structure is arranged to dissipate heat from at least one heat generating component (not shown in the figure, see instead figure 2) in the heat generating unit 4 to the heat output connector 8, where further the exchangeable heat sink unit 6 comprises a heat sink 10 and a heat sink heat dissipation structure 12 and a heat input connector 14, where the heat input connector 14 is arranged to connect to said heat output connector 8 to dissipate heat from said heat output connector 8 via the heat sink heat dissipation structure 12 to the heat sink 10.

The heat generating unit 4 is e.g. a radio unit, wherein the at least one heat generating component is e.g. a Printed Circuit Board (PCB), a component on a PCB or a Power Amplifier arranged in the heat generating radio unit.

The at least one heat generating component in the heat generating unit 4 is arranged in thermal contact with the heat dissipation structure, where heat from the at least one heat generating component is transferred to the heat dissipation structure preferably by conduction, whereby the at least one heat generating component is cooled whereas the heat dissipation structure is heated.

The heat dissipation structure may be a heat pipe arranged to transfer heat from the at least one heat generating component to the heat output connector 8.

A heat pipe is a closed structure arranged to transfer heat, i.e. thermal energy, from one end to the other using a two-phase flow, employing evaporative cooling by evaporation and condensation of a coolant. The fluid inside the heat pipe is evaporated at the heated end and reduces the temperature at the hot end of the pipe whereby the temperature is increased at the other end of the pipe as the coolant condenses and releases its latent heat and heats this end of the pipe, thus transferring heat between the pipe ends, i.e. from the at least one heat generating component to the heat output connector 8.

The heat dissipation structure may optionally be made of a material with high heat conductivity such as e.g. graphite, copper or gold arranged to transfer heat from the at least one heat generating component to the heat output connector 8.

The heat output connector 8 and the heat input connector 14 are arranged to be connected against each other in an assembled state of the cooling system 2 thereby allowing for heat transfer by conduction from the heat output connector 8 to the heat input connector 14.

The heat output connector 8 and the heat input connector 14 are of a plug-socket type, where the plug and the socket may be arranged as two large preferably cylindrical surfaces contacting each other over a large area for optimal heat transfer between the surfaces.

The heat output connector 8 and the heat input connector 14 are quick-connectors that are connected and disconnected with ease.

The heat output connector 8 may be one end of the heat dissipation structure.

The heat input connector 14 may be one end of the heat sink heat dissipation structure 12.

The heat sink heat dissipation structure 12 may be a heat pipe arranged to transfer heat from the heat input connector 14 to the heat sink 10.

The heat sink heat dissipation structure 12 may optionally be made of a material with high heat conductivity such as e.g. graphite, copper or gold arranged to transfer heat from the heat input connector 14 to the heat sink 10.

The heat sink heat dissipation structure 12 may optionally be a loop with coolant that is circulated in the exchangeable heat sink unit 6.

The heat from the heat sink 10 is transferred to the environment e.g. by that heat is transferred from the heat sink 10 to ambient air 16 surrounding the heat sink 10 whereby the ambient air 16 cools the heat sink 10. A forced air flow of ambient air 16 may be arranged to cool the heat sink 10.

Fig. 2 shows another schematic view of a cooling system according to the first embodiment of the invention for cooling a heat generating unit 4 in a disassembled state without heat sink for clarity of description. The cooling system 2 comprises an exchangeable heat sink unit 6 being in an assembled state of the cooling system 2 arranged removably connected to the heat generating unit 4 in an assembled state of the cooling system 2, where the cooling system 2 further comprises a heat dissipation structure 18 and a heat output connector 8 arranged in the heat generating unit 4, where the heat dissipation structure 18 is arranged to dissipate heat from at least one heat generating component 20 in the heat generating unit 4 to the heat output connector 8, where further the exchangeable heat sink unit 6 comprises a heat sink (not shown, see figure 1) and a heat sink heat dissipation structure 12 and a heat input connector 14, where the heat input connector 14 is arranged to connect to said heat output connector 8 to dissipate heat from said heat output connector 8 via the heat sink heat dissipation structure 12 to the heat sink.

The heat generating unit 4 is e.g. a radio unit, wherein the at least one heat generating component 20 is e.g. a Printed Circuit Board (PCB), a component on a PCB or a Power Amplifier arranged in the heat generating radio unit.

The at least one heat generating component 20 in the heat generating unit 4 is arranged in thermal contact with the heat dissipation structure 18, where heat from the at least one heat generating component 20 is transferred to the heat dissipation structure 18 preferably by conduction, whereby the at least one heat generating component 20 is cooled whereas the heat dissipation structure 18 is heated.

The heat dissipation structure 18 may be a heat pipe arranged to transfer heat from the at least one heat generating component 20 to the heat output connector 8.

The heat dissipation structure 18 may optionally be made of a material with high heat conductivity such as e.g. graphite, copper or gold arranged to transfer heat from the at least one heat generating component 20 to the heat output connector 8.

The heat output connector 8 and the heat input connector 14 are arranged to be connected against each other in an assembled state of the cooling system 2 thereby allowing for heat transfer by conduction from the heat output connector 8 to the heat input connector 14.

The heat output connector 8 may be one end of the heat dissipation structure 18.

The heat input connector 14 may be one end of the heat sink heat dissipation structure 12.

The heat sink heat dissipation structure 12 may be a heat pipe arranged to transfer heat from the heat input connector 14 to the heat sink.

The heat sink heat dissipation structure 12 may optionally be made of a material with high heat conductivity such as e.g. graphite, copper or gold arranged to transfer heat from the heat input connector 14 to the heat sink.

The heat sink heat dissipation structure 12 may optionally be a loop with coolant that is circulated in the exchangeable heat sink unit 6.

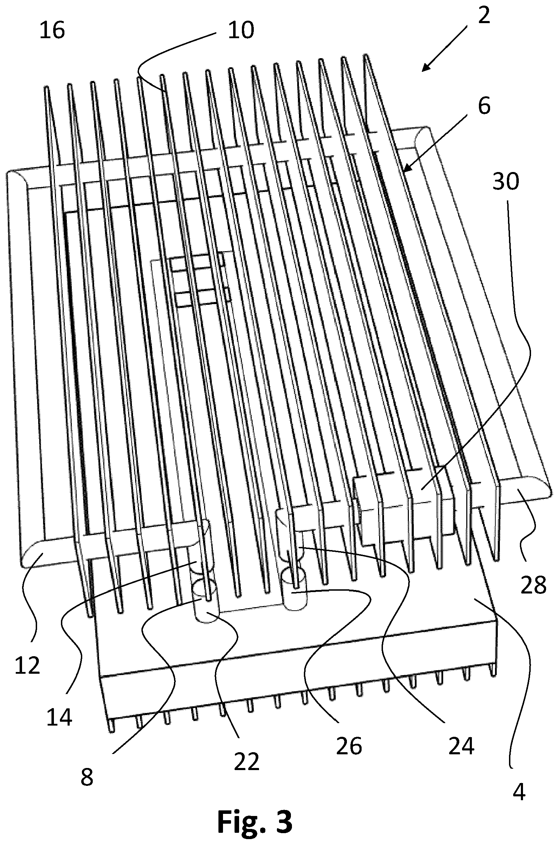

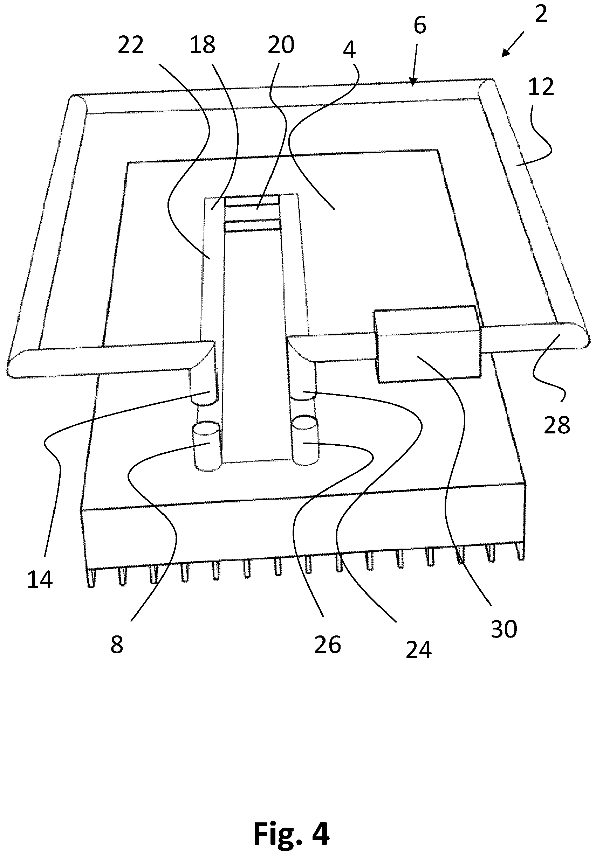

Fig. 3 shows a schematic view of a cooling system 2 according to a second embodiment of the invention for cooling a heat generating unit 4, where the cooling system 2 is shown in a disassembled state for clarity of description, the cooling system 2 comprising an exchangeable heat sink unit 6 being in an assembled state of the cooling system 2 arranged removably connected to the heat generating unit 4 in an assembled state of the cooling system 2, where the cooling system 2 further comprises a heat dissipation structure (not shown in the figure, see instead figure 4) and a heat output connector 8 arranged in the heat generating unit 4, where the heat dissipation structure is arranged to dissipate heat from at least one heat generating component (not shown in the figure, see instead figure 4) in the heat generating unit 4 to the heat output connector 8, where further the exchangeable heat sink unit 6 comprises a heat sink 10 and a heat sink heat dissipation structure 12 and a heat input connector 14, where the heat input connector 14 is arranged to connect to said heat output connector 8 to dissipate heat from said heat output connector 8 via the heat sink heat dissipation structure 12 to the heat sink 10.

The heat generating unit 4 is e.g. a radio unit, wherein the at least one heat generating component is e.g. a Printed Circuit Board (PCB), a component on a PCB or a Power Amplifier arranged in the heat generating radio unit.

The at least one heat generating component in the heat generating unit 4 is arranged in thermal contact with the heat dissipation structure, where heat from the at least one heat generating component is transferred to the heat dissipation structure preferably by conduction, whereby the at least one heat generating component is cooled whereas the heat dissipation structure is heated.

According to this embodiment, the heat dissipation structure is a coolant loop for coolant 22 arranged to transfer heat from the at least one heat generating component to the heat output connector 8.

The heat output connector 8 and the heat input connector 14 are arranged to be connected against each other in an assembled state of the cooling system 2 thereby allowing for heat transfer between the heat generating unit 4 and the heat sink unit 6 by mass transfer of coolant 22, i.e. fluid flow, between the heat generating unit 4 and the heat sink unit 6 from the heat output connector 8 to the heat input connector 14.

The heat output connector 8 and the heat input connector 14 may be of a plug-socket type.

The heat output connector 8 and the heat input connector 14 are preferably quick-connectors that are connected and disconnected with ease.

The heat output connector 8 may be one end of the heat dissipation structure.

The heat input connector 14 may be one end of the heat sink heat dissipation structure 12.

According to this embodiment, the heat sink heat dissipation structure 12 is a coolant loop for coolant 22 arranged to transfer heat from the heat input connector 14 to the heat sink 10.

According to this embodiment, the heat sink heat dissipation structure 12 comprises a coolant output connector 24 and the heat dissipation structure comprises a coolant input connector 26.

The coolant output connector 24 is further connected to the heat sink heat dissipation structure 12 which is a coolant loop for coolant 22.

The coolant input connector 26 is further connected to the heat dissipation structure which is a coolant loop for coolant 22.

Further, the coolant output connector 24 and the coolant input connector 26 are arranged to be connected against each other in an assembled state of the cooling system 2 thereby allowing for mass transfer of coolant 22 between the heat sink unit 6 and the heat generating unit 4 from the coolant output connector 24 to the coolant input connector 26. The heat dissipation structure and the heat sink heat dissipation structure 12 are thus arranged as mass transfer structures.

The heat from the heat sink 10 is transferred to the environment e.g. by that heat is transferred from the heat sink 10 to ambient air 16 surrounding the heat sink 10 whereby the ambient air 16 cools the heat sink 10. A forced air flow of ambient air 16 may be arranged to cool the heat sink 10.

Thus, the dissipation structure and the heat sink dissipation structure 12 form two sub-loops that are connected to form a coolant system loop 28 wherein coolant 22 is circulated between the heat generating unit 4 and the heat sink unit 6, the coolant transferring heat from the heat generating unit 4 to the heat sink unit 6 where heat is transferred to the environment thus cooling the at least one heat generating component.

The flow of coolant 22 may be enabled by arranging an active part 30 in the heat sink unit 6 arranged to circulate coolant 22 in the coolant system loop 28. The active part may be a pump or a compressor. The coolant may optionally be circulated in the system coolant loop 28 by gravity or capillary force. Thus, the coolant 22 may be circulated in the system coolant loop 28 by using a driving force or without using a driving force.

The coolant 22 may be a cooling medium such as e.g liquid or air or a 2-phase liquid-gas combination, or liquid metal.

The heat sink 10 comprises fins, which fins may be arranged with channels for the circulating coolant 22.

Fig. 4 shows another schematic view of a cooling system 2 according to the second embodiment of the invention for cooling a heat generating unit 4 in a disassembled state without heat sink for clarity of description. The cooling system 2 comprises an exchangeable heat sink unit 6 being in an assembled state of the cooling system 2 arranged removably connected to the heat generating unit 4 in an assembled state of the cooling system 2, where the cooling system 2 further comprises a heat dissipation structure 18 and a heat output connector 8 arranged in the heat generating unit 4, where the heat dissipation structure 18 is arranged to dissipate heat from at least one heat generating component 20 in the heat generating unit 4 to the heat output connector 8, where further the exchangeable heat sink unit 6 comprises a heat sink and a heat sink heat dissipation structure 12 and a heat input connector 14, where the heat input connector 14 is arranged to connect to said heat output connector 8 to dissipate heat from said heat output connector 8 via the heat sink heat dissipation structure 12 to the heat sink.

The heat generating unit 4 is e.g. a radio unit, wherein the at least one heat generating component is e.g. a Printed Circuit Board (PCB), a component on a PCB or a Power Amplifier arranged in the heat generating radio unit.

The at least one heat generating component 20 in the heat generating unit 4 is arranged in thermal contact with the heat dissipation structure 18, where heat from the at least one heat generating component 20 is transferred to the heat dissipation structure 18 preferably by conduction, whereby the at least one heat generating component 20 is cooled whereas the heat dissipation structure 18 is heated.

According to this embodiment, the heat dissipation structure 18 is a coolant loop for coolant 22 arranged to transfer heat from the at least one heat generating component 20 to the heat output connector 8.

The heat output connector 8 and the heat input connector 14 are arranged to be connected against each other in an assembled state of the cooling system 2 thereby allowing for heat transfer between the heat generating unit 4 and the heat sink unit 6 by mass transfer of coolant 22 between the heat generating unit 4 and the heat sink unit 6 from the heat output connector 8 to the heat input connector 14.

The heat output connector 8 and the heat input connector 14 may be of a plug-socket type.

The heat output connector 8 and the heat input connector 14 are preferably quick-connectors that are connected and disconnected with ease.

The heat output connector 8 may be one end of the heat dissipation structure 18.

The heat input connector 14 may be one end of the heat sink heat dissipation structure 12.

According to this embodiment, the heat sink heat dissipation structure 12 is a coolant loop for coolant 22 arranged to transfer heat from the heat input connector 14 to the heat sink.

According to this embodiment, the heat sink heat dissipation structure 12 comprises a coolant output connector 24 and the heat dissipation structure 18 comprises a coolant input connector 26.

The coolant output connector 24 is further connected to the heat sink heat dissipation structure 12 which is a coolant loop for coolant 22.

The coolant input connector 26 is further connected to the heat dissipation structure 18 which is a coolant loop for coolant 22.

Further, the coolant output connector 24 and the coolant input connector 26 are arranged to be connected against each other in an assembled state of the cooling system 2 thereby allowing for mass transfer of coolant 22 between the heat sink unit 6 and the heat generating unit 4 from the coolant output connector 24 to the coolant input connector 26. The heat dissipation structure 18 and the heat sink heat dissipation structure 12 are thus arranged as mass transfer structures.

The heat from the heat sink 10 is transferred to the environment e.g. by that heat is transferred from the heat sink 10 to ambient air 16 surrounding the heat sink whereby the ambient air 16 cools the heat sink. A forced air flow of ambient air 16 may be arranged to cool the heat sink 10.

Thus, the dissipation structure 18 and the heat sink dissipation structure 12 form two sub-loops that are connected to form a coolant system loop 28 wherein coolant 22 is circulated between the heat generating unit 4 and the heat sink unit 6, the coolant transferring heat from the heat generating unit 4 to the heat sink unit 6 where heat is transferred to the environment thus cooling the at least one heat generating component 20.

The flow of coolant 22 may be enabled by arranging an active part 30 in the heat sink unit 6 arranged to circulate coolant 22 in the coolant system loop 28. The active part may be a pump or a compressor. The coolant may optionally be circulated in the system coolant loop 28 by gravity or capillary force. Thus, the coolant 22 may be circulated in the system coolant loop 28 by using a driving force or without using a driving force.

The coolant 22 may be a cooling medium such as e.g liquid or air or a 2-phase liquid-gas combination, or liquid metal.

The heat sink may comprise fins, which fins may be arranged with channels for the circulating coolant 22.

The invention also relates to a method for cooling a heat generating unit 4 with a cooling system 2 comprising an exchangeable heat sink unit 6 being arranged removably connected to the heat generating unit 4 in an assembled state of the cooling system 2, comprising the steps of, arranging a heat dissipation structure 18 and a heat output connector 8 in the heat generating unit 4, arranging the heat dissipation structure 18 to dissipate heat from at least one heat generating component 20 in the heat generating unit 4 to the heat output connector 8, arranging a heat sink 10 and a heat sink heat dissipation structure 12 and a heat input connector 14 in the exchangeable heat sink unit 6, connecting the heat input connector 14 to said heat output connector 8 to dissipate heat from said heat output connector 8 via the heat sink heat dissipation structure 12 to the heat sink 10.

The step of arranging a heat dissipation structure 18 in the heat generating unit 4 may comprise the step of arranging a heat pipe as a heat dissipation structure 18 in the heat generating unit 4.

The step of arranging a heat dissipation structure 18 in the heat generating unit 4 may comprise the step of arranging a material with high heat conductivity as a heat dissipation structure 18 in the heat generating unit 4.

The step of arranging a heat sink heat dissipation structure 12 in the exchangeable heat sink unit 6 may comprise the step of arranging a heat pipe as a heat sink heat dissipation structure 12 in the exchangeable heat sink unit 6.

The step of arranging a heat sink heat dissipation structure 12 in the exchangeable heat sink unit 6 may comprise the step of arranging a material with high heat conductivity as a heat sink heat dissipation structure 12 in the exchangeable heat sink unit 6.

The step of arranging a heat dissipation structure 18 in the heat generating unit 4 may comprise the step of arranging coolant loop for coolant 22 arranged to transfer heat from the at least one heat generating component 20 to the heat output connector 8 as a heat dissipation structure 18 in the heat generating unit 4, where further the step of arranging a heat sink heat dissipation structure 12 in the heat sink unit 6 may comprise the step of arranging a coolant loop for coolant 22 arranged to transfer heat from the heat input connector 14 to the heat sink 10 as a heat sink heat dissipation structure 12 in the heat sink unit 4, where further the step of dissipating heat from said heat output connector 8 via the heat sink heat dissipation structure 12 to the heat sink 10 may comprise the step of transferring heat between the heat generating unit 4 and the heat sink unit 6 by mass transfer of coolant 22 between the heat dissipation structure 18 and the heat sink heat dissipation structure 12, the method further may comprise the steps of arranging the heat sink heat dissipation structure 12 with a coolant output connector 24 and arranging the heat dissipation structure 18 with a coolant input connector 26, and connecting the coolant output connector 24 and the coolant input connector 26 against each other in an assembled state of the cooling system 2 thereby allowing for return mass transfer of coolant 22 from the heat sink unit 6 to the heat generating unit 4.

The present invention is not limited to the embodiments described above, but also relates to and incorporates all embodiments within the scope of the appended independent claim. Thus, it is possible to combine features from the embodiments described above as long as the combinations are possible.

## Claims

1. Cooling system (2) for cooling a heat generating unit (4), the cooling system (2) comprising an exchangeable heat sink unit (6) being arranged to be removably connected to the heat generating unit (4) in an assembled state of the cooling system (2), wherein the cooling system (2) further comprises a heat dissipation structure (18) and a heat output connector (8), the heat dissipating structure (18) and the heat output connector (8) being adapted to be arranged in the heat generating unit (4), where the heat dissipation structure (18) is arranged to dissipate heat from at least one heat generating component (20) in the heat generating unit (4) to the heat output connector (8), where further the exchangeable heat sink unit (6) comprises a heat sink (10) and a heat sink heat dissipation structure (12) and a heat input connector (14), where the heat input connector (14) is arranged to connect to said heat output connector (8) to dissipate heat from said heat output connector (8) via the heat sink heat dissipation structure (12) to the heat sink (10), the heat dissipating structure (18) is adopted to be arranged in thermal contact with the at least one heat generating component (20) in the heat generating unit (4), the heat dissipation structure (18) is a coolant loop for coolant (22) arranged to transfer heat from the at least one heat generating component (20) to the heat output connector (8);
wherein the heat sink (10) comprises fins which are arranged with channels for the circulating coolant (22);
**characterized in that**
the heat output connector (8) and the heat input connector (14) are arranged to be connected against each other in an assembled state of the cooling system (2) thereby allowing for heat transfer by conduction from the heat output connector (8) to the heat input connector (14);
the heat output connector (8) and the heat input connector (14) are of a plug-socket type, where the plug and the socket are arranged as two preferably cylindrical surfaces contacting each other over an area for optimal heat transfer between the surfaces; and
the heat output connector (8) and the heat input connector (14) are quick-connectors that are connected and disconnected with ease.

2. Cooling system according to claim 1, wherein the heat generating unit (4) is a radio unit.

3. Cooling system according to claim 2, wherein the at least one heat generating component (20) is a Printed Circuit Board (PCB), a component on a PCB or a Power Amplifier arranged in the heat generating radio unit (4).

4. Cooling system according to claim 1, wherein the heat dissipation structure (18) is a heat pipe arranged to transfer heat from the at least one heat generating component (20) to the heat output connector (8).

5. Cooling system according to claim 1, wherein the heat dissipation structure (18) is made of a material with high heat conductivity arranged to transfer heat from the at least one heat generating component (20) to the heat output connector (8).

6. Cooling system according to claim 5, wherein the heat dissipation structure (18) is made of graphite, copper or gold.

7. Cooling system according to claim 1, wherein the heat output connector (8) is one end of the heat dissipation structure (18).

8. Cooling system according to claim 1, wherein the heat input connector (14) is one end of the heat sink heat dissipation structure (12).

9. Cooling system according to claim 1, wherein the heat sink heat dissipation structure (12) is a heat pipe arranged to transfer heat from the heat input connector (14) to the heat sink (10).

10. Cooling system according to claim 1, wherein the heat sink heat dissipation structure (12) is made of a material with high heat conductivity arranged to transfer heat from the heat input connector (14) to the heat sink (10).

11. Cooling system according to claim 10, wherein the heat sink heat dissipation structure (12) is made of graphite, copper or gold.

12. Cooling system according to claim 10, wherein heat from the heat sink (10) is arranged to be transferred to ambient air (16) surrounding the heat sink (10).

13. Cooling system according to claim 1, wherein the heat output connector (8) and the heat input connector (14) are arranged to be connected against each other in an assembled state of the cooling system (2) thereby allowing for heat transfer between the heat generating unit (4) and the heat sink unit (6) by mass transfer of coolant (22) between the heat generating unit (4) and the heat sink unit (6).

14. Cooling system according to claim 13, wherein the heat sink heat dissipation structure (12) is a coolant loop for coolant (22) arranged to transfer heat from the heat input connector (14) to the heat sink (10).

15. Cooling system according to claim 14 wherein the heat sink heat dissipation structure (12) comprises a coolant output connector (24) and the heat dissipation structure (18) comprises a coolant input connector (26).

16. Cooling system according to claim 15, wherein the coolant output connector (24) is further connected to the heat sink heat dissipation structure (12) which is a coolant loop for coolant (22).

17. Cooling system according to claim 16, wherein the coolant input connector (26) is further connected to the heat dissipation structure (18) which is a coolant loop for coolant (22).

18. Cooling system according to claim 17, wherein coolant output connector (24) and the coolant input connector (26) are arranged to be connected against each other in an assembled state of the cooling system (2) thereby allowing for mass transfer of coolant (22) between the heat sink unit (6) and the heat generating unit (4) from the coolant output connector (24) to the coolant input connector (26).

19. Cooling system according to claim 1, wherein the dissipation structure (18) and the heat sink dissipation structure (12) form two sub-loops that in an assembled state of the cooling system (2) are arranged to be connected to form a coolant system loop (28) wherein coolant (22) is circulated between the heat generating unit (4) and the heat sink unit (6), the coolant transferring heat from the heat generating unit (4) to the heat sink unit (6).

20. Cooling system according to claim 19, wherein an active part (30) is arranged in the heat sink unit (6) to circulate coolant (22) in the coolant system loop (28).

21. Cooling system according to claim 19, wherein the active part is a pump or a compressor.

22. Cooling system according to claim 1, wherein the coolant (22) is liquid or air or a 2-phase liquid-gas combination, or liquid metal.

23. Cooling system according to claim 1, wherein heat from the heat sink (10) is arranged to be transferred to ambient air (16) surrounding the heat sink (10).

24. Method for cooling a heat generating unit (4) with a cooling system (2) comprising an exchangeable heat sink unit (6) being arranged removably connected to the heat generating unit (4) in an assembled state of the cooling system (2), comprising the steps of arranging a heat dissipation structure (18) and a heat output connector (8) in the heat generating unit (4), arranging the heat dissipation structure (18) to dissipate heat from at least one heat generating component (20) in the heat generating unit (4) to the heat output connector (8), arranging a heat sink (10) and a heat sink heat dissipation structure (12) and a heat input connector (14) in the exchangeable heat sink unit (6), connecting the heat input connector (14) to said heat output connector (8) to dissipate heat from said heat output connector (8) via the heat sink heat dissipation structure (12) to the heat sink (10),
wherein the at least one heat generating component (20) in the heat generating unit (4) is arranged in thermal contact with the heat dissipation structure (18); and
wherein the heat dissipation structure (18) is a coolant loop for coolant (22) arranged to transfer heat from the at least one heat generating component (20) to the heat output connector (8),
wherein the heat sink (10) comprises fins which are arranged with channels for the circulating coolant (22);
**characterized in that**
the heat output connector (8) and the heat input connector (14) are arranged to be connected against each other in an assembled state of the cooling system (2) thereby allowing for heat transfer by conduction from the heat output connector (8) to the heat input connector (14);
the heat output connector (8) and the heat input connector (14) are of a plug-socket type, where the plug and the socket are arranged as two preferably cylindrical surfaces contacting each other over an area for optimal heat transfer between the surfaces; and
the heat output connector (8) and the heat input connector (14) are quick-connectors that are connected and disconnected with ease.

25. Method for cooling a heat generating unit (4) according to claim 24, where the step of arranging a heat dissipation structure (18) in the heat generating unit (4) comprises the step of arranging a heat pipe as a heat dissipation structure (18) in the heat generating unit (4).

26. Method for cooling a heat generating unit (4) according to claim 24, where the step of arranging a heat dissipation structure (18) in the heat generating unit (4) comprises the step of arranging a material with high heat conductivity as a heat dissipation structure (18) in the heat generating unit (4).

27. Method for cooling a heat generating unit (4) according to claim 24, where the step of arranging a heat sink heat dissipation structure (12) in the exchangeable heat sink unit (6) comprises the step of arranging a heat pipe as a heat sink heat dissipation structure (12) in the exchangeable heat sink unit (6).

28. Method for cooling a heat generating unit (4) according to claim 24, where the step of arranging a heat sink heat dissipation structure (12) in the exchangeable heat sink unit (6) comprises the step of arranging a material with high heat conductivity as a heat sink heat dissipation structure (12) in the exchangeable heat sink unit (6).

## Patentansprüche

1. Kühlsystem (2) zum Kühlen einer Wärmequelle (4), wobei das Kühlsystem (2) eine austauschbare Kühlkörpereinheit (6) umfasst, die angeordnet ist, in einem zusammengebauten Zustand des Kühlsystems (2) trennbar mit der Wärmequelle (4) verbunden zu sein, wobei das Kühlsystem (2) weiterhin eine Wärmeableitstruktur (18) und einen Wärmeausgabeanschluss (8) umfasst, wobei die Wärmeableitstruktur (18) und der Wärmeausgabeanschluss (8) eingerichtet sind, in der Wärmequelle (4) angeordnet zu werden, wobei die Wärmeableitstruktur (18) angeordnet ist, Wärme aus mindestens einer Wärme erzeugenden Komponente (20) in der Wärmequelle (4) an den Wärmeausgabeanschluss (8) abzuführen, wobei die austauschbare Kühlkörpereinheit (6) weiterhin einen Kühlkörper (10) und eine Kühlkörper-Wärmeableitstruktur (12) und einen Wärmeeingabeanschluss (14) umfasst, wobei der Wärmeeingabeanschluss (14) angeordnet ist, den Wärmeausgabeanschluss (8) zu verbinden, um Wärme aus dem Wärmeausgabeanschluss (8) über die Kühlkörper-Wärmeableitstruktur (12) an den Kühlkörper (10) abzuführen, die Wärmeableitstruktur (18) eingerichtet ist, in einem thermischen Kontakt mit der mindestens einen Wärme erzeugenden Komponente (20) in der Wärmequelle (4) angeordnet zu sein, die Wärmeableitstruktur (18) eine Kühlmittelschleife für Kühlmittel (22) ist, die angeordnet ist, Wärme aus der mindestens einen Wärme erzeugenden Komponente (20) an den Wärmeausgabeanschluss (8) zu übertragen; wobei der Kühlkörper (10) Rippen umfasst, die mit Kanälen zum Zirkulieren von Kühlmittel (22) angeordnet sind;
**dadurch gekennzeichnet, dass**
der Wärmeausgabeanschluss (8) und der Wärmeeingabeanschluss (14) angeordnet sind, in einem zusammengebauten Zustand des Kühlsystems (2) miteinander verbunden zu sein, wodurch eine Wärmeübertragung durch Leitung aus dem Wärmeausgabeanschluss (8) an den Wärmeeingabeanschluss (14) ermöglicht wird; der Wärmeausgabeanschluss (8) und der Wärmeeingabeanschluss (14) von einem Stecker-Sockeltyp sind, wobei der Stecker und der Sockel als zwei vorzugsweise zylindrische Oberflächen eingerichtet sind, die miteinander über eine Fläche zur optimalen Wärmeübertragung zwischen den Oberflächen in Kontakt stehen; und
der Wärmeausgabeanschluss (8) und der Wärmeeingabeanschluss (14) Schnellverbinder sind, die leicht verbunden und getrennt werden können.

2. Kühlsystem nach Anspruch 1, wobei die Wärmequelle (4) eine Funkanlage ist.

3. Kühlsystem nach Anspruch 2, wobei die mindestens eine Wärme erzeugende Komponente (20) eine Leiterplatte (PCB), eine Komponente auf einer PCB oder ein Leistungsverstärker ist, der in der Wärme erzeugenden Funkanlage (4) angeordnet ist.

4. Kühlsystem nach Anspruch 1, wobei die Wärmeableitstruktur (18) ein Wärmehohlleiter ist, der angeordnet ist, Wärme aus der mindestens einen Wärme erzeugenden Komponente (20) an den Wärmeausgabeanschluss (8) zu übertragen.

5. Kühlsystem nach Anspruch 1, wobei die Wärmeableitstruktur (18) aus einem Material mit hoher Wärmeleitfähigkeit angefertigt ist, das angeordnet ist, Wärme aus der mindestens einen Wärme erzeugenden Komponente (20) an den Wärmeausgabeanschluss (8) zu übertragen.

6. Kühlsystem nach Anspruch 5, wobei die Wärmeableitstruktur (18) aus Graphit, Kupfer oder Gold angefertigt ist.

7. Kühlsystem nach Anspruch 1, wobei der Wärmeausgabeanschluss (8) ein Ende der Wärmeableitstruktur (18) ist.

8. Kühlsystem nach Anspruch 1, wobei der Wärmeeingabeanschluss (14) ein Ende der Kühlkörper-Wärmeableitstruktur (12) ist.

9. Kühlsystem nach Anspruch 1, wobei die Kühlkörper-Wärmeableitstruktur (12) ein Wärmehohlleiter ist, der angeordnet ist, Wärme aus dem Wärmeeingabeanschluss (14) an den Kühlkörper (10) zu übertragen.

10. Kühlsystem nach Anspruch 1, wobei die Kühlkörper-Wärmeableitstruktur (12) aus einem Material mit hoher Wärmeleitfähigkeit angefertigt ist, das angeordnet ist, Wärme aus dem Wärmeeingabeanschluss (14) an den Kühlkörper (10) zu übertragen.

11. Kühlsystem nach Anspruch 10, wobei die Kühlkörper-Wärmeableitstruktur (12) aus Graphit, Kupfer oder Gold angefertigt ist.

12. Kühlsystem nach Anspruch 10, wobei Wärme aus dem Kühlkörper (10) eingerichtet ist, an Umgebungsluft (16) übertragen zu werden, die den Kühlkörper (10) umgibt.

13. Kühlsystem nach Anspruch 1, wobei der Wärmeausgabeanschluss (8) und der Wärmeeingabeanschluss (14) angeordnet sind, in einem zusammengebauten Zustand des Kühlsystems (2) miteinander verbunden zu sein, wodurch eine Wärmeübertragung zwischen der Wärmequelle (4) und der Kühlkörpereinheit (6) durch Masseübertragung von Kühlmittel (22) zwischen der Wärmequelle (4) und der Kühlkörpereinheit (6) ermöglicht wird.

14. Kühlsystem nach Anspruch 13, wobei die Kühlkörper-Wärmeableitstruktur (12) eine Kühlmittelschleife für Kühlmittel (22) ist, das angeordnet ist, Wärme aus dem Wärmeeingabeanschluss (14) an den Kühlkörper (10) zu übertragen.

15. Kühlsystem nach Anspruch 14, wobei die Kühlkörper-Wärmeableitstruktur (12) einen Kühlmittel-Ausgabeanschluss (24) umfasst und die Wärmeableitstruktur (18) einen Kühlmittel-Eingabeanschluss (26) umfasst.

16. Kühlsystem nach Anspruch 15, wobei der Kühlmittel-Ausgabeanschluss (24) ferner mit der Kühlkörper-Wärmeableitstruktur (12) verbunden ist, die eine Kühlmittelschleife für Kühlmittel (22) ist.

17. Kühlsystem nach Anspruch 16, wobei der Kühlmittel-Eingabeanschluss (26) ferner mit der Wärmeableitstruktur (18) verbunden ist, die eine Kühlmittelschleife für Kühlmittel (22) ist.

18. Kühlsystem nach Anspruch 17, wobei der Kühlmittel-Ausgabeanschluss (24) und der Kühlmittel-Eingabeanschluss (26) angeordnet sind, in einem zusammengebauten Zustand des Kühlsystems (2) miteinander verbunden zu sein, wodurch eine Masseübertragung von Kühlmittel (22) zwischen der Kühlkörpereinheit (6) und der Wärmequelle (4) aus dem Kühlmittel-Ausgabeanschluss (24) an den Kühlmittel-Eingabeanschluss (26) ermöglicht wird.

19. Kühlsystem nach Anspruch 1, wobei die Ableitstruktur (18) und die Kühlkörper-Ableitstruktur (12) zwei Unterschleifen ausbilden, die in einem zusammengebauten Zustand des Kühlsystems (2) angeordnet sind, verbunden zu sein, um eine Kühlmittel-Systemschleife (28) auszubilden, wobei Kühlmittel (22) zwischen der Wärmequelle (4) und der Kühlkörpereinheit (6) zirkuliert wird, wobei das Kühlmittel Wärme aus der Wärmequelle (4) an die Kühlkörpereinheit (6) überträgt.

20. Kühlsystem nach Anspruch 19, wobei ein aktives Bauteil (30) in der Kühlkörpereinheit (6) angeordnet ist, um Kühlmittel (22) in der Kühlmittel-Systemschleife (28) zu zirkulieren.

21. Kühlsystem nach Anspruch 19, wobei das aktive Bauteil eine Pumpe oder ein Kompressor ist.

22. Kühlsystem nach Anspruch 1, wobei das Kühlmittel (22) flüssig oder Luft oder eine 2-phasige Flüssigkeit-Gas-Kombination oder ein flüssiges Metall ist.

23. Kühlsystem nach Anspruch 1, wobei Wärme aus dem Kühlkörper (10) eingerichtet ist, an Umgebungsluft (16) übertragen zu werden, die den Kühlkörper (10) umgibt.

24. Verfahren zum Kühlen einer Wärmequelle (4) mit einem Kühlsystem (2), das eine austauschbare Kühlkörpereinheit (6) umfasst, die in einem zusammengebauten Zustand des Kühlsystems (2) trennbar mit der Wärmequelle (4) verbunden angeordnet ist, umfassend die Schritte des Anordnens einer Wärmeableitstruktur (18) und eines Wärmeausgabeanschlusses (8) in der Wärmequelle (4), des Anordnens der Wärmeableitstruktur (18), um Wärme aus mindestens einer Wärme erzeugenden Komponente (20) in der Wärmequelle (4) an den Wärmeausgabeanschluss (8) abzuführen, des Anordnens eines Kühlkörpers (10) und einer Kühlkörper-Wärmeableitstruktur (12) und eines Wärmeeingabeanschlusses (14) in der austauschbaren Kühlkörpereinheit (6), des Verbindens des Wärmeeingabeanschlusses (14) mit dem Wärmeausgabeanschluss (8), um Wärme aus dem Wärmeausgabeanschluss (8) über die Kühlkörper-Wärmeableitstruktur (12) an den Kühlkörper (10) abzuführen,
wobei die mindestens eine Wärme erzeugende Komponente (20) in der Wärmequelle (4) in thermischem Kontakt mit der Wärmeableitstruktur (18) angeordnet ist; und wobei die Wärmeableitstruktur (18) eine Kühlmittelschleife für Kühlmittel (22) ist, das eingerichtet ist, Wärme aus der mindestens einen Wärme erzeugenden Komponente (20) an den Wärmeausgabeanschluss (8) zu übertragen,
wobei der Kühlkörper (10) Rippen umfasst, die mit Kanälen zum Zirkulieren von Kühlmittel (22) angeordnet sind;
**dadurch gekennzeichnet, dass**
der Wärmeausgabeanschluss (8) und der Wärmeeingabeanschluss (14) angeordnet sind, in einem zusammengebauten Zustand des Kühlsystems (2) miteinander verbunden zu sein, wodurch eine Wärmeübertragung durch Leitung aus dem Wärmeausgabeanschluss (8) an den Wärmeeingabeanschluss (14) ermöglicht wird; der Wärmeausgabeanschluss (8) und der Wärmeeingabeanschluss (14) von einem Stecker-Sockeltyp sind, wobei der Stecker und der Sockel als zwei vorzugsweise zylindrische Oberflächen angeordnet sind, die miteinander über eine Fläche zur optimalen Wärmeübertragung zwischen den Oberflächen in Kontakt stehen; und
der Wärmeausgabeanschluss (8) und der Wärmeeingabeanschluss (14) Schnellverbinder sind, die leicht verbunden und getrennt werden können.

25. Verfahren zum Kühlen einer Wärmequelle (4) nach Anspruch 24, wobei der Schritt des Anordnens einer Wärmeableitstruktur (18) in der Wärmequelle (4) den Schritt des Anordnens eines Wärmehohlleiters als eine Wärmeableitstruktur (18) in der Wärmequelle (4) umfasst.

26. Verfahren zum Kühlen einer Wärmequelle (4) nach Anspruch 24, wobei der Schritt des Anordnens einer Wärmeableitstruktur (18) in der Wärmequelle (4) den Schritt des Anordnens eines Materials mit hoher Wärmeleitfähigkeit als eine Wärmeableitstruktur (18) in der Wärmequelle (4) umfasst.

27. Verfahren zum Kühlen einer Wärmequelle (4) nach Anspruch 24, wobei der Schritt des Anordnens einer Kühlkörper-Wärmeableitstruktur (12) in der austauschbaren Kühlkörpereinheit (6) den Schritt des Anordnens eines Wärmehohlleiters als eine Kühlkörper-Wärmeableitstruktur (12) in der austauschbaren Kühlkörpereinheit (6) umfasst.

28. Verfahren zum Kühlen einer Wärmequelle (4) nach Anspruch 24, wobei der Schritt des Anordnens einer Kühlkörper-Wärmeableitstruktur (12) in der austauschbaren Kühlkörpereinheit (6) den Schritt des Anordnens eines Materials mit hoher Wärmeleitfähigkeit als eine Kühlkörper-Wärmeableitstruktur (12) in der austauschbaren Kühlkörpereinheit (6) umfasst.

## Revendications

1. Système de refroidissement (2) pour refroidir une unité de génération de chaleur (4), le système de refroidissement (2) comprenant une unité de puits de chaleur (6) échangeable qui est agencée de façon à être raccordée de façon amovible à l'unité de génération de chaleur (4) dans un état assemblé du système de refroidissement (2), le système de refroidissement (2) comprenant en outre une structure de dissipation de chaleur (18) et un raccord de sortie de chaleur (8), la structure de dissipation de chaleur (18) et le raccord de sortie de chaleur (8) étant adaptés pour être agencés dans l'unité de génération de chaleur (4), la structure de dissipation de chaleur (18) étant agencée pour dissiper la chaleur provenant d'au moins un composant de génération de chaleur (20) dans l'unité de génération de chaleur (4) vers le raccord de sortie de chaleur (8), l'unité de puits de chaleur (6) échangeable comprenant en outre un puits de chaleur (10) et une structure de dissipation de chaleur de puits de chaleur (12) et un raccord d'entrée de chaleur (14), le raccord d'entrée de chaleur (14) étant agencé pour être raccordé audit raccord de sortie de chaleur (8) pour dissiper la chaleur provenant dudit raccord de sortie de chaleur (8) par l'intermédiaire de la structure de dissipation de chaleur de puits de chaleur (12) vers le puits de chaleur (10), la structure de dissipation de chaleur (18) étant adaptée pour être agencée en contact thermique avec le ou les composants de génération de chaleur (20) dans l'unité de génération de chaleur (4), la structure de dissipation de chaleur (18) étant une boucle de liquide de refroidissement pour le liquide de refroidissement (22) agencée pour transférer la chaleur du ou des composants de génération de chaleur (20) au raccord de sortie de chaleur (8) ;
le puits de chaleur (10) comprenant des ailettes qui sont agencées avec des canaux pour le liquide de refroidissement (22) en circulation ;
**caractérisé en ce que**
le raccord de sortie de chaleur (8) et le raccord d'entrée de chaleur (14) sont agencés pour être raccordés l'un à l'autre dans un état assemblé du système de refroidissement (2), permettant ainsi un transfert de chaleur par conduction du raccord de sortie de chaleur (8) au raccord d'entrée de chaleur (14) ;
le raccord de sortie de chaleur (8) et le raccord d'entrée de chaleur (14) étant d'un type à contact mâle et femelle, le contact mâle et le contact femelle étant agencés sous la forme de deux surfaces de préférence cylindriques en contact l'une avec l'autre sur une zone pour un transfert de chaleur optimal entre les surfaces ; et
le raccord de sortie de chaleur (8) et le raccord d'entrée de chaleur (14) étant des raccords rapides qui sont connectés et déconnectés avec facilité.

2. Système de refroidissement selon la revendication 1, l'unité de génération de chaleur (4) étant une unité radio.

3. Système de refroidissement selon la revendication 2, le ou les composants de génération de chaleur (20) étant une carte de circuit imprimé (PCB), un composant sur une PCB ou un amplificateur de puissance agencé dans l'unité radio de génération de chaleur (4).

4. Système de refroidissement selon la revendication 1, la structure de dissipation de chaleur (18) étant un caloduc agencé pour transférer la chaleur du ou des composants de génération de chaleur (20) au raccord de sortie de chaleur (8).

5. Système de refroidissement selon la revendication 1, dans lequel la structure de dissipation de chaleur (18) est constituée d'un matériau ayant une conductivité thermique élevée, agencé pour transférer la chaleur du ou des composants de génération de chaleur (20) au raccord de sortie de chaleur (8).

6. Système de refroidissement selon la revendication 5, la structure de dissipation de chaleur (18) étant constituée de graphite, de cuivre ou d'or.

7. Système de refroidissement selon la revendication 1, le raccord de sortie de chaleur (8) étant une extrémité de la structure de dissipation de chaleur (18).

8. Système de refroidissement selon la revendication 1, le raccord d'entrée de chaleur (14) étant une extrémité de la structure de dissipation de chaleur de puits de chaleur (12).

9. Système de refroidissement selon la revendication 1, la structure de dissipation de chaleur de puits de chaleur (12) étant un caloduc agencé pour transférer la chaleur du raccord d'entrée de chaleur (14) au puits de chaleur (10).

10. Système de refroidissement selon la revendication 1, la structure de dissipation de chaleur de puits de chaleur (12) étant constituée d'un matériau ayant une conductivité thermique élevée, agencé pour transférer la chaleur du raccord d'entrée de chaleur (14) au puits de chaleur (10).

11. Système de refroidissement selon la revendication 10, la structure de dissipation de chaleur de puits de chaleur (12) étant constituée de graphite, de cuivre ou d'or.

12. Système de refroidissement selon la revendication 10, la chaleur provenant du puits de chaleur (10) étant agencée pour être transférée à l'air ambiant (16) entourant le puits de chaleur (10).

13. Système de refroidissement selon la revendication 1, dans lequel le raccord de sortie de chaleur (8) et le raccord d'entrée de chaleur (14) sont agencés pour être raccordés l'un à l'autre dans un état assemblé du système de refroidissement (2), permettant ainsi un transfert de chaleur entre l'unité de génération de chaleur (4) et l'unité de puits de chaleur (6) par transfert de masse de liquide de refroidissement (22) entre l'unité de génération de chaleur (4) et l'unité de puits de chaleur (6).

14. Système de refroidissement selon la revendication 13, dans lequel la structure de dissipation de chaleur de puits de chaleur (12) est une boucle de liquide de refroidissement pour le liquide de refroidissement (22) agencée pour transférer la chaleur du raccord d'entrée de chaleur (14) au puits de chaleur (10).

15. Système de refroidissement selon la revendication 14, la structure de dissipation de chaleur de puits de chaleur (12) comprenant un raccord de sortie de liquide de refroidissement (24) et la structure de dissipation de chaleur (18) comprenant un raccord d'entrée de liquide de refroidissement (26).

16. Système de refroidissement selon la revendication 15, le raccord de sortie de liquide de refroidissement (24) étant en outre raccordé à la structure de dissipation de chaleur de puits de chaleur (12) qui est une boucle de liquide de refroidissement pour le liquide de refroidissement (22).

17. Système de refroidissement selon la revendication 16, le raccord d'entrée de liquide de refroidissement (26) étant en outre raccordé à la structure de dissipation de chaleur (18) qui est une boucle de liquide de refroidissement pour le liquide de refroidissement (22).

18. Système de refroidissement selon la revendication 17, dans lequel le raccord de sortie de liquide de refroidissement (24) et le raccord d'entrée de liquide de refroidissement (26) sont agencés pour être raccordés l'un à l'autre dans un état assemblé du système de refroidissement (2), permettant ainsi un transfert de masse de liquide de refroidissement (22) entre l'unité de puits de chaleur (6) et l'unité de génération de chaleur (4), du raccord de sortie de liquide de refroidissement (24) au raccord d'entrée de liquide de refroidissement (26).

19. Système de refroidissement selon la revendication 1, dans lequel la structure de dissipation (18) et la structure de dissipation de puits de chaleur (12) forment deux sous-boucles qui, dans un état assemblé du système de refroidissement (2), sont agencées pour être raccordées pour former une boucle de système de liquide de refroidissement (28), un liquide de refroidissement (22) étant mis en circulation entre l'unité de génération de chaleur (4) et l'unité de puits de chaleur (6), le liquide de refroidissement transférant la chaleur de l'unité de génération de chaleur (4) à l'unité de puits de chaleur (6).

20. Système de refroidissement selon la revendication 19, une partie active (30) étant agencée dans l'unité de puits de chaleur (6) pour faire circuler un liquide de refroidissement (22) dans la boucle de système de liquide de refroidissement (28).

21. Système de refroidissement selon la revendication 19, la partie active étant une pompe ou un compresseur.

22. Système de refroidissement selon la revendication 1, le liquide de refroidissement (22) étant un liquide ou de l'air ou une combinaison liquide-gaz à 2 phases, ou un métal liquide.

23. Système de refroidissement selon la revendication 1, la chaleur provenant du puits de chaleur (10) étant agencée pour être transférée à l'air ambiant (16) entourant le puits de chaleur (10).

24. Procédé de refroidissement d'une unité de génération de chaleur (4) avec un système de refroidissement (2) comprenant une unité de puits de chaleur (6) échangeable qui est agencée raccordée de manière amovible à l'unité de génération de chaleur (4) dans un état assemblé du système de refroidissement (2), comprenant les étapes consistant à agencer une structure de dissipation de chaleur (18) et un raccord de sortie de chaleur (8) dans l'unité de génération de chaleur (4), agencer la structure de dissipation de chaleur (18) pour dissiper la chaleur provenant d'au moins un composant de génération de chaleur (20) dans l'unité de génération de chaleur (4) vers le raccord de sortie de chaleur (8), agencer un puits de chaleur (10) et une structure de dissipation de chaleur de puits de chaleur (12) et un raccord d'entrée de chaleur (14) dans l'unité de puits de chaleur (6) échangeable, raccorder le raccord d'entrée de chaleur (14) audit raccord de sortie de chaleur (8) pour dissiper la chaleur provenant dudit raccord de sortie de chaleur (8) par l'intermédiaire de la structure de dissipation de chaleur de puits de chaleur (12) vers le puits de chaleur (10),
le ou les composants de génération de chaleur (20) dans l'unité de génération de chaleur (4) étant agencés en contact thermique avec la structure de dissipation de chaleur (18) ; et
la structure de dissipation de chaleur (18) étant une boucle de liquide de refroidissement pour le liquide de refroidissement (22) agencée pour transférer la chaleur du ou des composants de génération de chaleur (20) au raccord de sortie de chaleur (8),
le puits de chaleur (10) comprenant des ailettes qui sont agencées avec des canaux pour le liquide de refroidissement (22) en circulation ;
**caractérisé en ce que**
le raccord de sortie de chaleur (8) et le raccord d'entrée de chaleur (14) sont agencés pour être raccordés l'un à l'autre dans un état assemblé du système de refroidissement (2), permettant ainsi un transfert de chaleur par conduction, du raccord de sortie de chaleur (8) au raccord d'entrée de chaleur (14) ;
le raccord de sortie de chaleur (8) et le raccord d'entrée de chaleur (14) sont d'un type à contacts mâle et femelle, le contact mâle et le contact femelle étant agencés sous la forme de deux surfaces de préférence cylindriques en contact l'une avec l'autre sur une zone pour un transfert de chaleur optimal entre les surfaces ; et
le raccord de sortie de chaleur (8) et le raccord d'entrée de chaleur (14) étant des raccords rapides qui sont connectés et déconnectés avec facilité.

25. Procédé de refroidissement d'une unité de génération de chaleur (4) selon la revendication 24, l'étape d'agencement d'une structure de dissipation de chaleur (18) dans l'unité de génération de chaleur (4) comprenant l'étape consistant à agencer un caloduc en tant que structure de dissipation de chaleur (18) dans l'unité de génération de chaleur (4).

26. Procédé de refroidissement d'une unité de génération de chaleur (4) selon la revendication 24, l'étape consistant à agencer une structure de dissipation de chaleur (18) dans l'unité de génération de chaleur (4) comprenant l'étape consistant à agencer un matériau ayant une conductivité thermique élevée en tant que structure de dissipation de chaleur (18) dans l'unité de génération de chaleur (4).

27. Procédé de refroidissement d'une unité de génération de chaleur (4) selon la revendication 24, l'étape consistant à agencer une structure de dissipation de chaleur de puits de chaleur (12) dans l'unité de puits de chaleur (6) échangeable comprenant l'étape consistant à agencer un caloduc en tant que structure de dissipation de chaleur de puits de chaleur (12) dans l'unité de puits de chaleur (6) échangeable.

28. Procédé de refroidissement d'une unité de génération de chaleur (4) selon la revendication 24, l'étape consistant à agencer une structure de dissipation de chaleur de puits de chaleur (12) dans l'unité de puits de chaleur (6) échangeable comprenant l'étape consistant à agencer un matériau ayant une conductivité thermique élevée en tant que structure de dissipation de chaleur de puits de chaleur (12) dans l'unité de puits de chaleur (6) échangeable.
